# EUROPEAN PATENT APPLICATION

(11) **EP 4 826 114 A1**
(43) Date of publication of application: **21.10.2026**
(21) Application number: 25751117.0
(22) Date of filing: 16.01.2025
(51) Int. Cl.: C23C 14/50, C23C 16/458, H01L 21/673

(54) **CARRIER PLATE DEVICE**

(30) Priority: 07.02.2024 CN 202410173117
(71) Applicant: Suzhou Maxwell Technologies Co., Ltd., Suzhou, Jiangsu 215200 (CN)
(72) Inventor: ZHOU, Jian, Suzhou, Jiangsu 215200 (CN); SONG, Wenhua, Suzhou, Jiangsu 215200 (CN); PENG, Xiaolong, Suzhou, Jiangsu 215200 (CN); HU, Chen, Suzhou, Jiangsu 215200 (CN); LIU, Yanan, Suzhou, Jiangsu 215200 (CN)
(74) Representative: Balder IP Law, S.L.
(86) International application number: PCT/CN2025/072779
(87) International publication number: WO 2025/167515

(57) **Abstract**

A carrier assembly comprises a support frame (100) and at least one tray (200), wherein the tray (200) is mounted to the support frame (100). The tray (200) includes a main body (210) and support ribs (220) connected to the main body (210). A first side of the main body (210) is configured to support substrates; the support ribs (220) are attached to a second side of the main body (210) so that the first side of the main body (210) forms an upwardly protruding curved surface.

## Description

This application claims priority to Chinese Patent Application No. 202410173117.3 filed with the China National Intellectual Property Administration on February 7, 2024, the entire contents of which are incorporated herein by reference.

### TECHNICAL FIELD

The present application relates to the technical field of semiconductor manufacturing, and in particular, to a carrier assembly.

### BACKGROUND

The length of the effective loading area of a carrier is generally fixed due to equipment limitations. Nevertheless, the width of the effective loading area can be adjusted by varying the center-to-center distance between adjacent silicon wafer placement positions. A smaller center-to-center distance enables more silicon wafers to be accommodated within the effective loading area, thereby increasing the wafer area occupancy ratio on the carrier; conversely, the occupancy ratio decreases.

In the industry, the entire assembly configured to carry silicon wafers for film deposition is generally defined as a carrier, which comprises trays and a frame for holding the trays. Each tray is an independent carrier member on the carrier for loading silicon wafers. Main beams disposed on opposite sides of the frame are in contact with conveying rollers, and the carrier is conveyed by the conveying rollers. In practical operation, when the center-to-center distance between adjacent wafer placement positions is reduced to increase the wafer area occupation ratio, the ribs between adjacent hollowed-out receiving openings on the tray become excessively narrow, which degrades the structural strength of the tray. After the tray is mounted to the carrier frame, the tray sags, deteriorating the overall flatness of the carrier and leading to a substantial increase in failures of automatic wafer pick-and-place operations. In addition, when the frame vibrates during conveyance, such vibration is transmitted to the trays and causes position deviation of wafers placed on the trays, which impairs the uniformity of film deposition and also results in an increased failure rate of automatic wafer pick-and-place operations. Furthermore, temperature rise of the trays during film deposition causes thermal deformation of the trays, which results in position deviation of the wafers placed on the trays and inadequate contact between the deformed trays and the wafers. This impairs film deposition uniformity and may cause electrical shorting between the front and rear surfaces of coated wafers, degrading the electrical performance of solar cells.

### SUMMARY

The present application provides a carrier assembly with a high wafer area occupation ratio and enhanced structural strength of trays, which ensures the overall flatness of the carrier assembly and reduces the occurrence of faults in automatic wafer pick-and-place.

Disclosed herein is a carrier assembly, comprising: a support frame; and at least one tray, the tray being mounted to the support frame, the tray comprises a main body and support ribs connected to the main body, a first side of the main body is configured to support substrates, and the support ribs are connected to a second side of the main body.

In some embodiments, the main body is provided with a plurality of receiving portions; each receiving portion is configured to receive one substrate, the plurality of receiving portions are arranged in multiple rows and columns, and the support ribs are disposed between two adjacent rows of the receiving portions and extend along the row direction.

In some embodiments, the main body has a fixing edge extending along the contour thereof; the support frame comprises a frame body and at least one support beam assembly mounted within the frame body, and the fixing edge is connected to the support beam assembly via connecting assemblies.

In some embodiments, a plurality of connecting assemblies are disposed at intervals along the contour of the main body.

In some embodiments, each of the connecting assemblies comprises: a limiting block mounted to a first side of the main body, a buffer gap defined between the limiting block and the tray; a connecting bolt extending through the support beam assembly, the main body and the limiting block; a connecting nut threaded onto the connecting bolt; and a connecting washer fitted onto the connecting bolt and sandwiched between the connecting nut and the limiting block.

In some embodiments, the main body is provided with a mounting groove; the limiting block comprises an insertion portion and an abutting portion, the insertion portion is fitted into the mounting groove, and the abutting portion is connected to the insertion portion and abuts against the connecting washer.

In some embodiments, the frame body comprises: a plurality of first main beams arranged in parallel, each first main beam extending along a first direction; and two second main beams extending along a second direction, the two second main beams connected respectively to opposite ends of the plurality of first main beams, with a buffer zone defined between the second main beams and the support beam assembly in the first direction.

In some embodiments, the frame body further comprises reinforcing beams disposed within at least one of the first main beams and the second main beams.

In some embodiments, the frame body further comprises baffles disposed within the buffer zone.

In some embodiments, the support beam assembly comprises: a plurality of first support beams, each extending along the first direction and connected to the frame body; and a plurality of second support beams, each extending along the second direction with opposite ends connected respectively to two parallel first support beams.

In some embodiments, each second support beam comprises a cross beam and support heads connected to opposite ends of the cross beam, and the support heads are connected to the first support beams via locking assemblies; each locking assembly comprises a locking bolt, a locking nut and a locking washer; the locking bolt passes through the support head and the first support beam, the locking nut is threadedly engaged with the locking bolt, and the locking washer is fitted onto the locking bolt and sandwiched between the locking nut and the first support beam.

### BRIEF DESCRIPTION OF THE DRAWINGS

FIG. 1 is a schematic structural view of the carrier assembly according to an embodiment of the present application;
FIG. 2 is a schematic structural view of a tray of the embodiment of the present application;
FIG. 3 is a schematic structural view of a support frame of the carrier assembly according to the embodiment of the present application;
FIG. 4 is a sectional view of the connecting structure between the tray and the support frame according to an embodiment of the present application;
FIG. 5 is an enlarged partial schematic view of the support frame at the connecting position between a baffle and a second main beam according to an embodiment of the present application;
FIG. 6 is an enlarged partial schematic view of the support frame at the connecting position between the baffle and a second support beam according to an embodiment of the present application;
FIG. 7 is an enlarged partial schematic view of the support frame at the connecting position between the first support beam and the second support beam according to an embodiment of the present application;
FIG. 8 is a sectional view of the first main beam of the support frame according to an embodiment of the present application;
FIG. 9 is an enlarged partial structural view of the carrier assembly at the position between two adjacent trays according to an embodiment of the present application..

### Reference Numerals:

100-support frame,110-frame body, 111-first main beam, 1111-reinforcing beam,112-second main beam, 113-baffle, 120-support beam assembly, 121-first support beam, 122-second support beam, 1221-support head,1222-cross beam;
200-tray; 210-main body; 211-fixing edge; 2111-mounting groove; 212-receiving portion; 220-support rib;
300-connecting assembly; 310-limiting block; 311-plug-in portion; 312-abutting portion; 320-connecting bolt; 330-connecting nut; 340-connecting washer;
400-locking assembly; 410-locking bolt; 420-locking nut; 430-locking washer;
500-first mounting assembly; 510-first mounting bolt; 520-first mounting nut; 530-first mounting washer;
600 second mounting assembly; 610 second mounting bolt; 620 second mounting nut; 630 second mounting washer; 640 third mounting washer;
700 fixing assembly; 710 fixing bolt; 720 fixing nut; 730 first fixing washer; 740-second fixing washer.

### DETAILED DESCRIPTION OF THE EMBODIMENTS

The technical solutions of the present application are described below with reference to the accompanying drawings in conjunction with specific embodiments.

In the description of the present application, it is to be understood that terms including "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial" and "circumferential" denote orientations or positional relationships based on those illustrated in the accompanying drawings. Such terms are used solely for the convenience of description and simplification, and do not indicate or imply that the relevant device or component must be configured and operated in any particular orientation. Accordingly, these terms shall not be interpreted as limiting the scope of the present application.

Furthermore, features qualified by the modifiers "first" and "second" may explicitly or implicitly encompass one or more such features. These modifiers serve merely to distinguish features and carry no implication of order or priority. Unless otherwise specified herein, the term "a plurality of" refers to two or more.

In the description of the present application, it is to be noted that unless otherwise expressly specified and limited, the terms "mount", "link" and "connect" shall be construed in a broad sense. For instance, such connection may be fixed connection, detachable connection or integral connection; may be mechanical connection or electrical connection; may be direct connection, indirect connection via an intermediate member, or internal intercommunication between two components. Those of ordinary skill in the pertinent art may construe the meaning of the aforesaid terms in the present application according to actual circumstances.

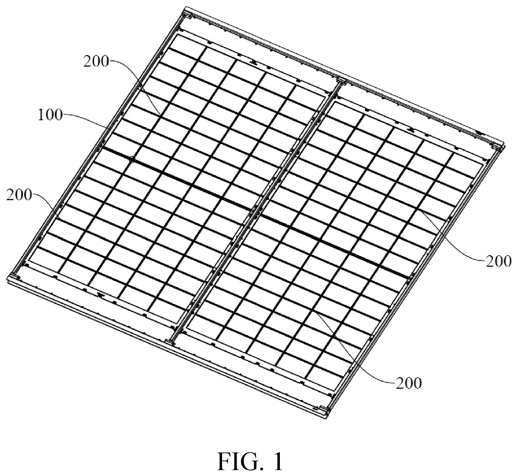

The structure of the carrier assembly according to an embodiment of the present application is described below with reference to FIG. 1 to FIG. 9.

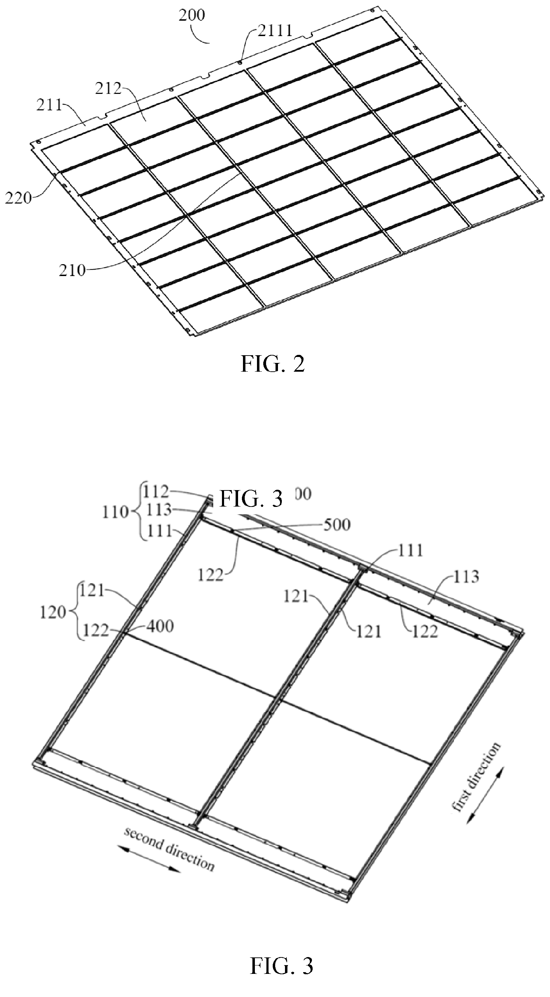

Disclosed herein is a carrier assembly. As shown in FIG. 1 and FIG. 2, the carrier assembly includes a support frame 100 and at least one tray 200 mounted to the support frame 100. The tray 200 comprises a main body 210 and support ribs 220 connected to the main body 210. A first side of the main body 210 is arranged for supporting substrates, and the support ribs 220 are connected to a second side of the main body 210 such that the first side of the main body 210 forms an upwardly protruding curved surface. It can be appreciated that since the tray 200 includes a main body 210 and support ribs 220 connected to the main body 210, the support ribs 220 can enhance the overall strength of the tray 200 and reduce deformation thereof. Due to the reinforcement provided by the support ribs 220, the support ribs 220 arranged between two adjacent hollow positions (for receiving substrates) on the main body 210 can be designed to have a relatively narrow width. Accordingly, the effective substrate occupancy ratio of the carrier assembly can be increased while maintaining the overall structural strength of the tray 200. Meanwhile, during actual processing, welding the support ribs 220 to the second side of the main body 210 causes the first side of the main body 210 to form an upwardly protruding curved surface. After the tray 200 is mounted toto the support frame 100, the upwardly protruding deformation on the first side can counteract the sagging deformation of the entire tray 200 caused by gravity, ensure the overall flatness of the carrier assembly and reduce the probability of abnormal automatic loading.

It should be noted that during manufacture of the tray 200, both ends of the main body 210 are placed on cushion blocks so that the main body 210 sags naturally. The support ribs 220 are then welded to the main body 210 at a plurality of welding points, and the welding points enable the main body 210 to form an upwardly protruding arched shape.

As shown in FIG. 2, the main body 210 is provided with a plurality of receiving portions 212 each configured to hold one substrate. The plurality of receiving portions 212 are arranged in multiple rows and columns, and the support ribs 220 are disposed between every two adjacent rows of the receiving portions 212 and extend along the row direction. It will be appreciated that the receiving portions 212 are arranged in multiple rows and columns, with each receiving portion 212 capable of receiving one substrate, which increases the loading capacity of the tray 200 and thus improves the loading capacity of the carrier assembly. In addition, the support ribs 220 disposed between adjacent rows of the receiving portions 212 can effectively improve the structural strength of the main body 210 and enhance the overall strength of the tray 200.

As shown in FIG. 2 and FIG. 3, the main body 210 has a fixing edge 211 extending along the contour thereof. The support frame 100 comprises a frame body 110 and at least one support beam assembly 120 mounted inside the frame body 110, and the fixing edge 211 is connected to the support beam assembly 120 via connecting assemblies 300. It will be appreciated that the main body 210 is fixed to the support frame 100 via the connection between the fixing edge 211 and the support beam assembly 120. The relatively large contact area between the fixing edge 211 and the support frame 100 ensures that the support frame 100 can stably support the main body 210.

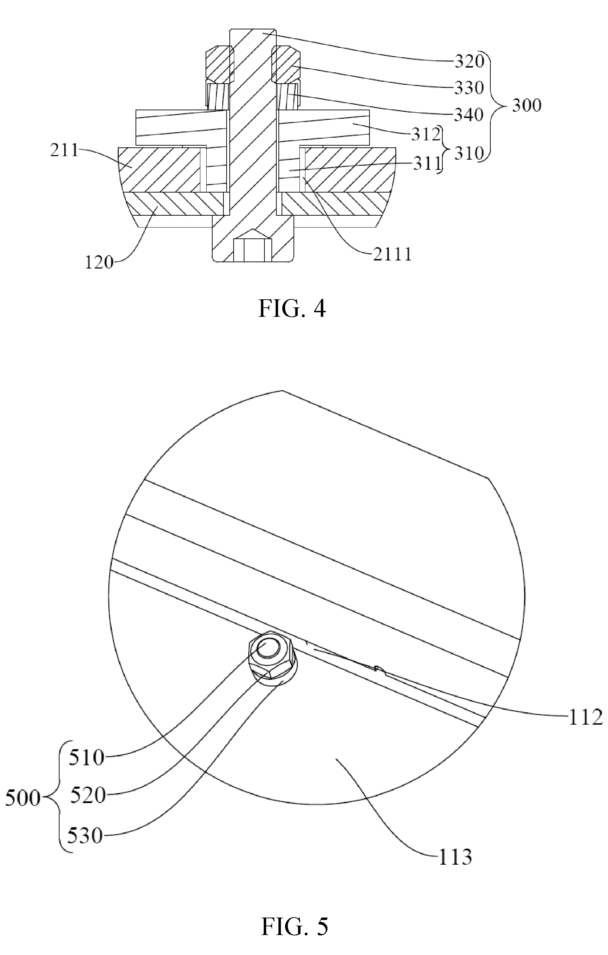

As shown in FIG. 4, the connecting assembly 300 includes a limiting block 310, a connecting bolt 320, a connecting nut 330 and a connecting washer 340. The limiting block 310 is mounted to the first side of the fixing edge 211, with buffer gaps reserved between the limiting block 310 and the tray 200 in both horizontal and vertical directions. The connecting bolt 320 extends through the support beam assembly 120, the fixing edge 211 and the limiting block 310. The connecting nut 330 is threadedly fitted onto the connecting bolt 320, and the connecting washer 340 is fitted onto the connecting bolt 320 and sandwiched between the connecting nut 330 and the limiting block 310.It will be appreciated that during actual assembly. the limiting block 310 is first mounted to the first side of the main body 210. Thereafter, the connecting bolt 320 extends upward from below through the support beam assembly 120, the fixing edge 211 and the limiting block 310. The connecting washer 340 is then fitted onto the connecting bolt 320, followed by tightening with the connecting nut 330. Such a connection structure enhances the connection reliability between the tray 200 and the support frame 100 on one hand. On the other hand, the reserved vertical buffer gaps allow free release of thermal expansion and contraction of the tray 200 caused by temperature variation during heating and cooling cycles, so as to effectively avoid deformation of the large-sized tray 200.

Optionally, as shown in FIG. 4, the fixing edge 211 is provided with a mounting groove 2111. The limiting block 310 includes an insertion portion 311 and an abutting portion 312. The insertion portion 311 is fitted into the mounting groove 2111, and the abutting portion 312 is connected to the insertion portion 311 and abuts against the connecting washer 340. It can be appreciated that the insertion portion 311 is fitted into the mounting groove 2111, leaving buffer gaps in both horizontal and vertical directions, which adequately accommodate thermal expansion and contraction of the tray 200 induced by temperature fluctuations and effectively resolve the deformation issue of the large-sized tray 200. Moreover, the limiting block 310 confines the deformation of the tray 200 within a consistent range, resulting in uniform deformation of the substrate-bearing masking area on the tray 200. This avoids incomplete masking, which would otherwise cause unintended electrical conduction between the front and rear surfaces of coated solar cells and impair cell conversion efficiency.

Optionally, a plurality of connecting assemblies 300 are arranged at intervals along the contour of the main body 210. It is understood that the multiple connecting assemblies 300 improve the connection stability between the fixing edge 211 and the support beam assembly 120, and accordingly enhance the overall connection stability between the tray 200 and the support frame 100.

As shown in FIG. 3, the frame body 110 includes a plurality of first main beams 111 and two second main beams 112. The first main beams 111 are arranged in parallel and each extends along the first direction. The two second main beams 112 extend along the second direction and are connected to opposite ends of the plurality of first main beams 111 respectively. The support beam assembly 120 is composed of a plurality of first support beams 121 and a plurality of second support beams 122. Each first support beam 121 extends along the first direction and is fixed to the first main beam 111; each second support beam 122 extends along the second direction, with its two opposite ends connected to two parallel first support beams 121 respectively.

In addition, a buffer zone is reserved between the second main beams 112 and the support beam assembly 120 along the first direction. Since the tray is conveyed along the second direction, the second main beams 112 of the frame body are in contact with conveying rollers. Vibration generated during conveyance would otherwise be transmitted to the tray 200 and induce substrate displacement as well as non-uniform film deposition. Therefore, the buffer zone is configured to reduce vibration transmission to the tray 200.

Optionally, the frame body 110 is further provided with baffles 113 disposed within the buffer zone. Two opposite sides of each baffle 113 along the first direction are connected to the second main beam 112 and the second support beam 122 respectively. The film deposition process adopts double-sided top-and-bottom deposition. If the buffer zone is left hollow, stray coating will occur inside the vacant space, so the baffles 113 are arranged to block stray coating. It can be appreciated that the frame body 110, composed of a plurality of first main beams 111, a plurality of second main beams 112 and baffles 113, features high structural rigidity to ensure the overall flatness of the carrier assembly. Meanwhile, such structural layout simplifies the frame configuration, reduces the frame weight and facilitates transportation and handling. Furthermore, the internal space of the frame body 110 is partitioned into a plurality of independent receiving regions by a plurality of first support beams 121 and a plurality of second support beams 122, with one tray 200 arranged inside each region. This arrangement strengthens the supporting effect for the trays 200 and improves the mounting stability of the trays on the support frame 100. In addition, the baffles 113 effectively suppress stray coating during film deposition, so as to secure satisfactory overall flatness of the carrier assembly and uniformity of film deposition.

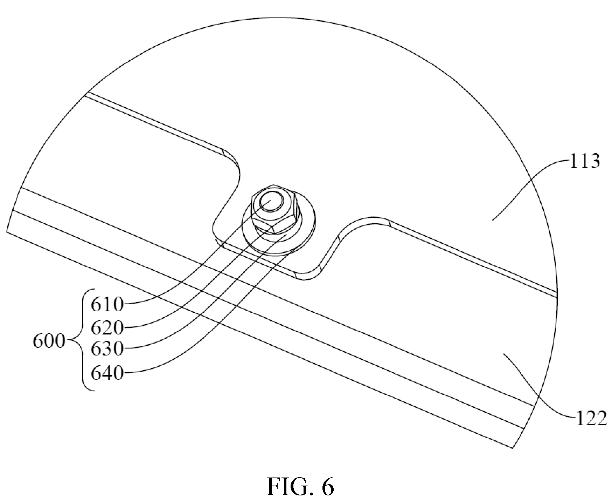

As shown in FIG. 5 and FIG. 6, opposite sides of the baffles 113 along the first direction are connected to the second main beam 112 and the second support beam 122 via a first mounting assembly 500 and a second mounting assembly 600 respectively. Such configuration facilitates assembly and improves the connection reliability among the baffles 113, the second main beam 112 and the second support beam 122.

As illustrated in FIG. 5, the first mounting assembly 500 includes a first mounting bolt 510, a first mounting nut 520 and a first mounting washer 530. The first mounting bolt 510 penetrates upward sequentially through the second main beam 112 and the baffles 113; the first mounting nut 520 is threadably engaged with the first mounting bolt 510, and the first mounting washer 530 is fitted onto the first mounting bolt 510 and sandwiched between the first mounting nut 520 and the baffles 113. The fastening cooperation of the first mounting bolt 510 and the first mounting nut 520 realizes fixed connection between the baffles 113 and the second main beam 112, which simplifies assembling steps and enhances connection strength therebetween. In addition, the arranged first mounting washer 530 prevents the first mounting nut 520 from spinning loose during repeated assembly and disassembly operations.

As shown in FIG. 6, the second mounting assembly 600 includes a second mounting bolt 610, a second mounting nut 620, a second mounting washer 630 and a third mounting washer 640. The second mounting bolt 610 penetrates upward sequentially through the second support beam 122 and the baffles 113. The second mounting nut 620 is threadably fitted onto the second mounting bolt 610, while the second mounting washer 630 and the third mounting washer 640 are fitted onto the second mounting bolt 610 and sandwiched between the second mounting nut 620 and the baffles 113. The fastening cooperation between the second mounting bolt 610 and the second mounting nut 620 achieves fixed connection between the baffles 113 and the second support beam 122, simplifying assembly procedures and increasing the connection strength therebetween. Furthermore, the additional arranged second mounting washer 630 and third mounting washer 640 prevent the second mounting nut 620 from spinning loose during repeated assembly and disassembly.

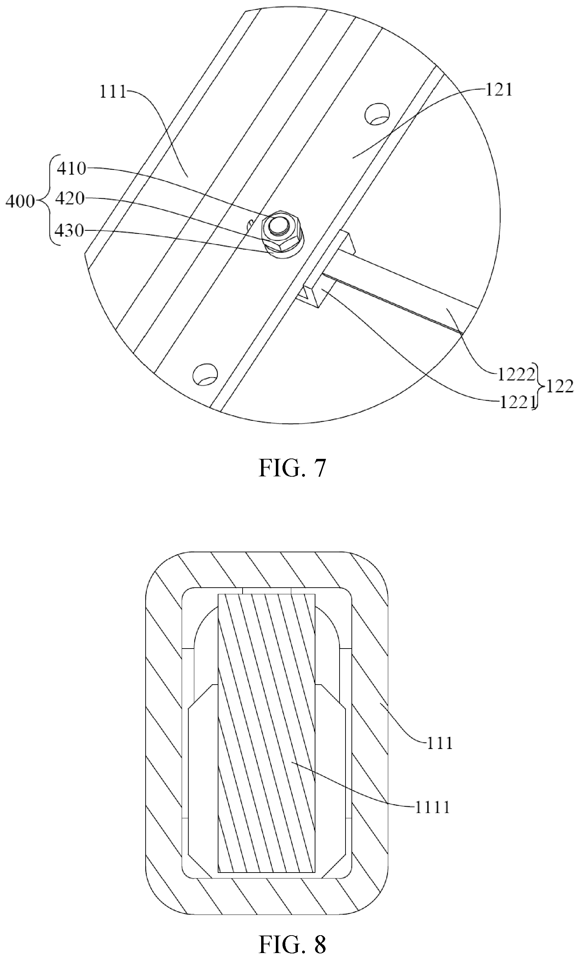

As shown in FIG. 7, each second support beam 122 includes a cross beam 1222 and support heads 1221 connected to opposite ends of the cross beam 1222. The support heads 1221 are connected to the first support beams 121 via locking assemblies 400. Each locking assembly 400 comprises a locking bolt 410, a locking washer 430 and a locking nut 420. The locking bolt 410 penetrates through the support head 1221 and the first support beam 121; the locking nut 420 is threadably engaged with the locking bolt 410, and the locking washer 430 is fitted onto the locking bolt 410 and sandwiched between the locking nut 420 and the first support beam 121.It is understandable that during actual assembly, the support heads 1221 are welded to the cross beam 1222 in advance. Thereafter, the locking bolt 410 is inserted upward from below sequentially through the support head 1221 and the first support beam 121, the locking washer 430 is fitted onto the locking bolt 410, and final fastening is achieved by tightening the locking nut 420. This tructural layout facilitates assembly and enhances the connection reliability between the second support beam 122 and the first support beam 121.

As shown in FIG. 8, the frame body 110 further comprises reinforcing beams 1111 disposed inside a plurality of respective first main beams 111. It is understandable that the additionally arranged reinforcing beams 1111 enhance the rigidity of the first main beams 111 and further improve the overall structural strength of the frame body 110.

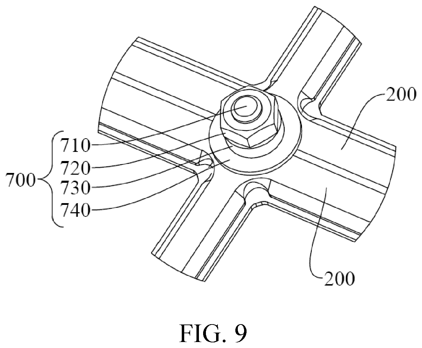

As shown in FIG. 9, fixing assemblies 700 are disposed in gaps between a plurality of adjacent trays 200. Each fixing assembly 700 comprises a fixing bolt 710, a fixing nut 720, a first fixing washer 730 and a second fixing washer 740. The fixing bolt 710 penetrates through the second support beam 122; the fixing nut 720, the first fixing washer 730 and the second fixing washer 740 are fitted onto the fixing bolt 710, and the second fixing washer 740 abuts the two adjacent trays 200. Accordingly, the fixing assemblies 700 compress the paired trays 200 onto the second support beam 122 to further increase the mounting stability of the trays 200 on the support frame 100.

### Embodiment:

As illustrated in FIG. 1 to FIG. 9, the carrier assembly includes one support frame 100 and four trays 200. The support frame 100 includes a frame body 110 and two support beam assemblies 120 disposed within the frame body 110. The frame body 110 comprises three first main beams 111, two second main beams 112 and two baffles 113. The three first main beams 111 are arranged in parallel and each extends along the first direction; the two second main beams 112 extend along the second direction and are connected to opposite ends of the three first main beams 111 respectively. A reinforcing beam 1111 is disposed inside each first main beam 111.Each support beam assembly 120 comprises two first support beams 121 and three second support beams 122. Each first support beam 121 extends along the first direction and is connected to the first main beam 111; each second support beam 122 extends along the second direction, with its two ends connected to a pair of parallel first support beams 121. Each second support beam 122 comprises a cross beam 1222 and support heads 1221 connected to opposite ends of the cross beam 1222, and the support heads 1221 are connected to the first support beams 121 via locking assemblies 400. Each locking assembly 400 comprises a locking bolt 410, a locking nut 420 and a locking washer 430. The locking bolt 410 penetrates through the support head 1221 and the first support beam 121; the locking nut 420 is threadably engaged with the locking bolt 410, and the locking washer 430 is fitted onto the locking bolt 410 and sandwiched between the locking nut 420 and the first support beam 121.Each baffle 113 is connected to the second main beam 112 and the second support beam 122 through a first mounting assembly 500 and a second mounting assembly 600 respectively. The first mounting assembly 500 comprises a first mounting bolt 510, a first mounting nut 520 and a first mounting washer 530. The first mounting bolt 510 runs upward sequentially through the second main beam 112 and the baffle 113; the first mounting nut 520 is threadably engaged with the first mounting bolt 510, and the first mounting washer 530 is fitted onto the first mounting bolt 510 and sandwiched between the first mounting nut 520 and the baffle 113.The second mounting assembly 600 comprises a second mounting bolt 610, a second mounting nut 620, a second mounting washer 630 and a third mounting washer 640. The second mounting bolt 610 penetrates upward sequentially through the second support beam 122 and the baffle 113; the second mounting nut 620 is threadedly engaged with the second mounting bolt 610, while the second mounting washer 630 and the third mounting washer 640 are fitted onto the second mounting bolt 610 and sandwiched between the second mounting nut 620 and the baffle 113.

The trays 200 are mounted to the support frame 100. Each tray 200 comprises a main body 210 and support ribs 220 connected to the main body 210. The main body 210 is provided with forty receiving portions 212 each configured to carry one substrate, which are arranged in an array of eight rows and five columns. The support ribs 220 are disposed between every two adjacent rows of the receiving portions 212 and extend along the row direction. The main body 210 is formed with a fixing edge 211 extending along its peripheral contour, and the fixing edge 211 is connected to two first support beams 121 and two second support beams 122 via connecting assemblies 300. Each connecting assembly 300 comprises a limiting block 310, a connecting bolt 320, a connecting nut 330 and a connecting washer 340. The limiting block 310 is fitted onto the first side of the fixing edge 211. For part of the connecting assemblies 300, the connecting bolt 320 penetrates upward sequentially through the support beam assembly 120 (i.e., the first support beam 121 or the second support beam 122), the fixing edge 211 and the limiting block 310. The connecting nut 330 is threadedly engaged with the connecting bolt 320, and the connecting washer 340 is fitted onto the connecting bolt 320 and sandwiched between the connecting nut 330 and the limiting block 310.The fixing edge 211 is provided with mounting grooves 2111. The limiting block 310 comprises an insertion portion 311 and an abutting portion 312; the insertion portion 311 is inserted into the mounting groove 2111, and the abutting portion 312 is connected with the insertion portion 311 and abuts against the connecting washer 340.Fixing assemblies 700 are disposed in gaps between adjacent trays 200. Each fixing assembly 700 comprises a fixing bolt 710, a fixing nut 720, a first fixing washer 730 and a second fixing washer 740. The fixing bolt 710 passes through the second support beam 122; the fixing nut 720, the first fixing washer 730 and the second fixing washer 740 are fitted onto the fixing bolt 710, and the second fixing washer 740 abuts the two adjacent trays 200.

In the description of this specification, reference to expressions such as "some embodiments", "other embodiments" means that specific features, structures, materials or characteristics described in conjunction with the embodiment or example are incorporated into at least one embodiment or example of the present application. In this specification, schematic expressions of the foregoing expressions do not necessarily refer to the identical embodiment or example. Moreover, the described features, structures, materials or characteristics may be combined in any suitable manner in one or more embodiments or examples.

## Claims

1. A carrier assembly, **characterized in that** comprising:
a support frame (100); and
at least one tray (200), the tray (200) being mounted to the support frame (100), the tray (200) comprises a main body (210) and support ribs (220) connected to the main body (210), a first side of the main body (210) is configured to support substrates, and the support ribs (220) are connected to a second side of the main body (210).

2. The carrier assembly according to claim 1, **characterized in that** the main body (210) is provided with a plurality of receiving portions (212); each receiving portion (212) is configured to receive one substrate, the plurality of receiving portions (212) are arranged in multiple rows and columns, and the support ribs (220) are disposed between two adjacent rows of the receiving portions (212) and extend along the row direction.

3. The carrier assembly according to claim 1, **characterized in that** the main body (210) has a fixing edge (211) extending along the peripheral contour thereof; the support frame (100) comprises a frame body (110) and at least one support beam assembly (120) mounted within the frame body (110), and the fixing edge (211) is connected to the support beam assembly (120) via connecting assemblies (300).

4. The carrier assembly according to claim 3, **characterized in that** a plurality of connecting assemblies (300) are disposed at intervals along the contour of the main body (210).

5. The carrier assembly according to claim 4, **characterized in that** each of the connecting assemblies (300) comprises:
a limiting block (310) mounted to a first side of the main body (210), a buffer gap defined between the limiting block (310) and the tray (200);
a connecting bolt (320) extending through the support beam assembly (120), the main body (210) and the limiting block (310);
a connecting nut (330) threaded onto the connecting bolt (320); and
a connecting washer (340) fitted onto the connecting bolt (320) and sandwiched between the connecting nut (330) and the limiting block (310).

6. The carrier assembly according to claim 5, **characterized in that** the main body (210) is provided with a mounting groove (2111); the limiting block (310) comprises an insertion portion (311) and an abutting portion (312), the insertion portion (311) is fitted into the mounting groove (2111), and the abutting portion (312) is connected to the insertion portion (311) and abuts the connecting washer (340).

7. The carrier assembly according to claim 3, **characterized in that** the frame body (110) comprises:
a plurality of first main beams (111) arranged in parallel, each first main beam (111) extending along a first direction; and two second main beams (112) extending along a second direction, the two second main beams (112) connected respectively to opposite ends of the plurality of first main beams (111), with a buffer zone defined between the second main beams (112) and the support beam assembly (120) in the first direction.

8. The carrier assembly according to claim 7, **characterized in that** the frame body (110) further comprises reinforcing beams (1111) disposed within at least one of the first main beams (111) and the second main beams (112).

9. The carrier assembly according to claim 7, **characterized in that** the frame body (110) further comprises baffles (113) disposed within the buffer zone.

10. The carrier assembly according to claim 3, **characterized in that** the support beam assembly (120) comprises:
a plurality of first support beams (121), each extending along the first direction and connected to the frame body (110); and
a plurality of second support beams (122), each extending along the second direction with opposite ends connected respectively to two parallel first support beams (121);
each second support beam (122) comprises a cross beam (1222) and support heads (1221) connected to opposite ends of the cross beam (1222), and the support heads (1221) are connected to the first support beams (121) via locking assemblies (400);
each locking assembly (400) comprises a locking bolt (410), a locking nut (420) and a locking washer (430); the locking bolt (410) passes through the support head (1221) and the first support beam (121), the locking nut (420) is threadedly engaged with the locking bolt (410), and the locking washer (430) is fitted onto the locking bolt (410) and sandwiched between the locking nut (420) and the first support beam (121).
